# EUROPEAN PATENT APPLICATION

(11) **EP 4 450 683 A1**
(43) Date of publication of application: **23.10.2024**
(21) Application number: 22907081.8
(22) Date of filing: 08.11.2022
(51) Int. Cl.: C30B 13/20, H05B 6/10, H05B 6/40

(54) **INDUCTION HEATING COIL AND SINGLE CRYSTAL PRODUCTION DEVICE USING SAME**

(30) Priority: 14.12.2021 JP 2021202509
(71) Applicant: Sumco Corporation, Minato-ku, Tokyo 105-8634 (JP)
(72) Inventor: SUGITA, Yoshinori, Omura-shi Nagasaki 856-8555 (JP); SHIMOMURA, Koichi, Omura-shi Nagasaki 856-8555 (JP); UEDA, Ryosuke, Omura-shi Nagasaki 856-8555 (JP)
(74) Representative: Kraus & Lederer PartGmbB
(86) International application number: PCT/JP2022/041537
(87) International publication number: WO 2023/112550

(57) **Abstract**

To provide an induction heating coil capable of reducing a variation in the height of the melt surface of a raw material rod and thus stably growing a single crystal and a single crystal manufacturing apparatus using the same.

An induction heating coil 20 comprises an annular coil body 21 that has an opening 22 in the center thereof and that has a first end 21e₁ and a second end 21e₂ separated from each other by a slit 23 extending in a substantially radial direction from the opening 22. The slit 23 is an oblique slit that obliquely cuts the coil body 21 from an upper surface 21a side thereof to a lower surface 21b side such that a corner on the upper surface 21a side of the first end 21e₁ has an acute angle and that a corner on the upper surface 21a side of the second end 21e₂ has an obtuse angle. The upper surface 21a of the coil body 21 has an upper stage surface 21a₁ and a lower stage surface 21a₂, the lower stage surface 21a₂ is provided at a slit neighborhood area on the first end 21e₁ side, and the upper stage surface 21a₁ is provided in an area excluding a formation area of the lower stage surface 21a₂.

## Description

### [Technical Field]

The present invention relates to an induction heating coil used to manufacture a single crystal according to an FZ (Floating Zone) method and a single crystal manufacturing apparatus using the induction heating coil.

### [Background Art]

An FZ method is known as a manufacturing method for a silicon single crystal. In the FZ method, a part of a polycrystalline silicon raw material rod is heated to form a melting zone, and the raw material rod and a seed crystal positioned respectively above and below the melting zone are slowly lowered to grow a large single crystal above the seed crystal. Unlike a CZ (Czochralski) method, the FZ method does not use a quartz crucible and thus can manufacture a single crystal with a low oxygen concentration.

The FZ method uses an induction heating system to heat a polycrystalline silicon raw material. In the induction heating system, a magnetic field, which is generated when a high-frequency current is made to flow in an induction heating coil, is applied to a silicon raw material to cause an eddy current to flow in the silicon raw material through electromagnetic induction, thereby generating Joule heat due to the eddy current, and the generated Joule heat is used to heat the silicon raw material.

As to the induction heating coil, for example, Patent Document 1 describes a method of uniformizing heating distribution on the silicon crystal side by locally forming a groove in the surface of the induction heating coil on the single crystal side so as to reduce the resistance variation of the single crystal. Patent Document 2 discloses a method of movably inserting an insulating member into a slit formed in the induction heating coil. Examples of the slit cross-sectional shape include a vertical type slit, an oblique type slit, and a crank type slit.

### [Citation List]

### [Patent Document]

[Patent Document 1] Japanese Patent No. 2914077
[Patent Document 2] Japanese Patent Laid-open Publication No. 2012-232859

### [Disclosure of the Invention]

### [Problem to be Solved by the Invention]

For the FZ method, there has been a demand for a raw material rod having a large diameter in order to improve the yield of a single crystal. However, an increase in the diameter of the raw material rod makes it difficult to uniformly heat the entire part in the peripheral direction of the raw material rod, thus locally increasing the melted amount of the raw material to increase a variation in the height of the melt surface of the raw material in the peripheral direction. This melt surface non-uniform in height finally contacts the coil surface to result in interruption of the manufacturing process.

It is therefore an object of the present invention to provide an induction heating coil capable of reducing a variation in the height of the melt surface of a raw material rod and thus stably growing a single crystal and a single crystal manufacturing apparatus using such an induction heating coil.

### [Means for Solving the Problem]

To solve the above problem, there is provided an induction heating coil according to the present invention used to manufacture a single crystal by an FZ method, the induction heating coil comprising an annular coil body that has an opening in the center thereof and that has first and second ends separated from each other by a slit extending in a substantially radial direction from the opening. The slit is an oblique slit that obliquely cuts the coil body from an upper surface side thereof to a lower surface side such that a corner on the upper surface side of the first end has an acute angle and that a corner on the upper surface side of the second end has an obtuse angle. The upper surface of the coil body has an upper stage surface and a lower stage surface. The lower stage surface is provided at a slit neighborhood area on the first end side, and the upper stage surface is provided in the area excluding the formation area of the lower stage surface.

When the slit of the induction heating coil is formed obliquely in cross section, one corner and the other corner opposite to each other across the slit have an acute angle and an obtuse angle, respectively, and current is likely to be concentrated on the acute-angled corner, resulting in very large heat generation from the slit neighborhood area having the acute-angled corner. However, when the height of the upper surface on the first end side having the acute-angled corner is reduced, it is possible to reduce circumferential deviation of the heating distribution of the melt surface due to the concentration of current around the slit. Thus, a height variation of the melt surface of the raw material rod can be reduced to allow stable growth of a single crystal.

A height difference between the upper and lower stage surfaces is preferably 2 mm or more. In this case, A thickness of the coil body in the formation area of the lower stage surface is preferably smaller than a thickness of the coil body in a formation area of the upper stage surface. This can make effective the measures of providing the height difference to the upper surface of the coil main bod to thereby reduce circumferential deviation of the heating distribution due to the concentration of current around the slit.

The formation area of the upper stage surface preferably includes the slit neighborhood area on the second end side. This reduces a heating distribution difference between the left and right sides of the slit to make it possible to reduce circumferential deviation of the heating distribution.

When a direction of a center line of the slit extending in a substantially radial direction from the center of the opening is assumed to be 0°, the lower stage surface preferably circumferentially extends in an angular range of at least 0° to 30°. Preferably, in this case, the lower stage surface circumferentially extends in an angular range of 0° to 90°, and the upper stage surface circumferentially extends in an angular range of at least 180° to 360°. Alternatively, a configuration may be possible in which the lower stage surface circumferentially extends in an angular range of 0° to 180°, and the upper stage surface circumferentially extends in an angular range of at least 180° to 360°. This reduces a heating distribution difference in the circumferential direction to make it possible to reduce a height variation of the melt surface of the raw material rod in the circumferential direction.

A single crystal manufacturing apparatus according to the present invention is a single crystal manufacturing apparatus used to manufacture a single crystal by an FZ method, the apparatus comprising: an upper shaft that rotatably and vertically movably supports a raw material rod; a lower shaft that is disposed below the upper shaft and rotatably and vertically movably supports a seed crystal; and the above-mentioned induction heating coil according to the present invention that heats the raw material rod.

According to the present invention, there can be provided a single crystal manufacturing apparatus capable of reducing a circumferential height variation of the melt surface of the raw material rod and thus stably growing a single crystal.

### [Advantageous Effect of the Invention]

According to the present invention, there can be provided an induction heating coil capable of reducing a circumferential height variation of the melt surface of a raw material rod and thus of stably growing a single crystal and a single crystal manufacturing apparatus using such an induction heating coil.

### [Brief Description of the Drawings]

FIG. 1 is a schematic view illustrating the configuration of a single crystal manufacturing apparatus according to an embodiment of the present invention.
FIG. 2 is a schematic perspective view illustrating the configuration of the induction heating coil according to a first embodiment of the present invention.
FIGS. 3A and 3B are configuration views of the induction heating coil illustrated in FIG. 2, in which FIG. 3A is a plan view, and FIG. 3B is a cross-sectional view taken along the line X-X' in FIG. 3A.
FIG. 4A is a view illustrating the height profile of the upper surface of a coil body, and FIG. 4B is a cross-sectional view of a slit.
FIG. 5 is a schematic view illustrating a current flow inside the coil body.
FIGS. 6A and 6B are schematic views for explaining the coil shape according to the present invention, in which FIG. 6A is a conventional coil shape, and FIG. 6B is a coil shape of the present invention.
FIGS. 7A and 7B are views illustrating the configuration of the induction heating coil according to a second embodiment of the present invention, in which FIG. 7A is a plan view, and FIG. 7B is a view illustrating the height profile of the upper surface of the coil body.
FIGS. 8A and 8B are views illustrating the configuration of the induction heating coil according to a third embodiment of the present invention, in which FIG. 8A is a plan view, and FIG. 8B is a view illustrating the height profile of the upper surface of the coil body.
FIGS. 9A and 9B are views illustrating the configuration of the induction heating coil according to a fourth embodiment of the present invention, in which FIG. 9A is a plan view, and FIG. 9B is a view illustrating the height profile of the upper surface of the coil body.
FIGS. 10A and 10B are views illustrating the configuration of the induction heating coil 20 according to a fifth embodiment of the present invention, in which FIG. 10A is a plan view, and FIG. 10B is a view illustrating the height profile of the upper surface of the coil body.
FIGS. 11A and 11B are views illustrating an action (problems) of a conventional induction heating coil, in which FIG. 11A is a molten state when heated in the right side of the slit, and FIG. 11B is a molten state when heated in the left side of the slit.
FIGS.12A and 12B are views illustrating an action (problems) of the induction heating coil according to the present embodiment, in which FIG. 11A is a molten state when heated in the right side of the slit, and FIG. 11B is a molten state when heated in the left side of the slit.
FIG. 13 is a graph illustrating a result of measuring the distance between the raw material melt surface and the coil when growing a single crystal using the induction heating coil according to the comparative example.
FIG. 14 is a graph illustrating a result of measuring the distance between the raw material melt surface and the coil when growing a single crystal using the induction heating coil according to the example.

### [Mode for Carrying Out the Invention]

Hereinafter, preferred embodiments of the present invention will be described in detail with reference to the accompanying drawings.

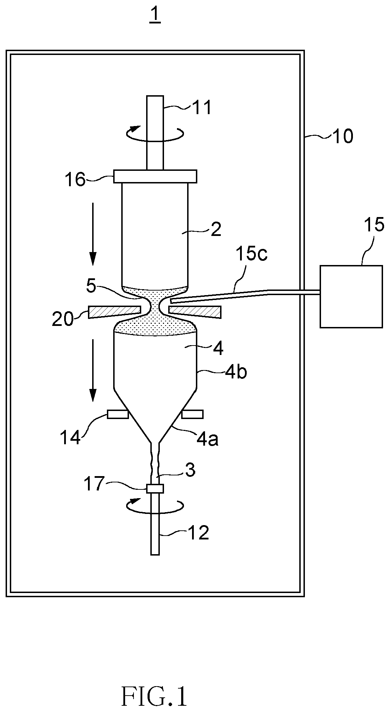

FIG. 1 is a schematic view illustrating the configuration of a single crystal manufacturing apparatus according to an embodiment of the present invention.

As illustrated in FIG. 1, a single crystal manufacturing apparatus 1 is an apparatus for growing a silicon single crystal using an FZ method. The single crystal manufacturing apparatus 1 includes: a reaction furnace 10 accommodating a raw material rod 2, a seed crystal 3, and a silicon single crystal 4 grown on the seed crystal 3; an upper shaft 11 that rotatably and vertically movably supports the raw material rod 2; a lower shaft 12 that rotatably and vertically movably supports the seed crystal 3 and silicon single crystal 4; an induction heating coil 20 for heating the lower end portion of the raw material rod 2; a single crystal weight holder 14 that supports the weight of the silicon single crystal 4 that has been grown to a large size; and a gas doping apparatus 15 for supplying a dopant gas to a melting zone 5 (molten silicon) between the raw material rod 2 and the silicon single crystal 4.

The raw material rod 2 is made from high-purity polycrystalline silicon obtained by purifying a silicon raw material, such as monosilane or trichlorosilane, and is attached, at its upper end portion, to the lower end portion of the upper shaft 11 through a raw material holder 16. The seed crystal 3 is attached, at its lower end portion, to the upper end portion of the lower shaft 12 through a seed crystal holder 17. The upper and lower shafts 11 and 12 are each rotated and vertically moved by a not-shown drive mechanism.

The induction heating coil 20 is a high-frequency coil of substantially one turn that surrounds the melting zone 5 or raw material rod 2 and is connected to a not illustrated high-frequency oscillator. The induction heating coil 20 is preferably mainly made of copper or silver. By making a high-frequency current to flow in the induction heating coil 20, the lower end portion of the raw material rod 2 is induction-heated to thereby produce the melting zone 5. The seed crystal 3 is fused to the thus produced melting zone 5, and then the raw material rod 2 and seed crystal 3 are lowered while being rotated, whereby the silicon single crystal 4 can be grown from the melting zone 5.

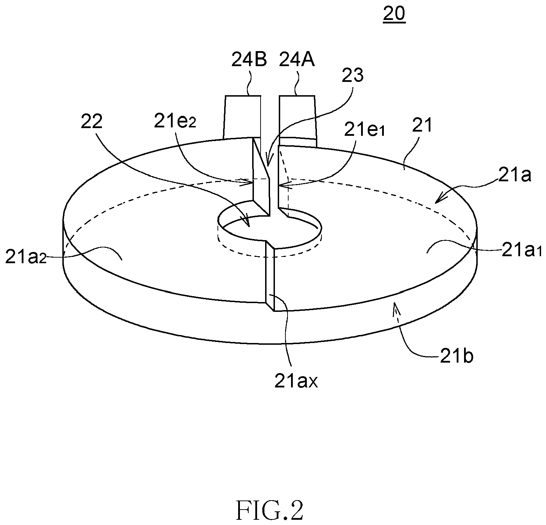

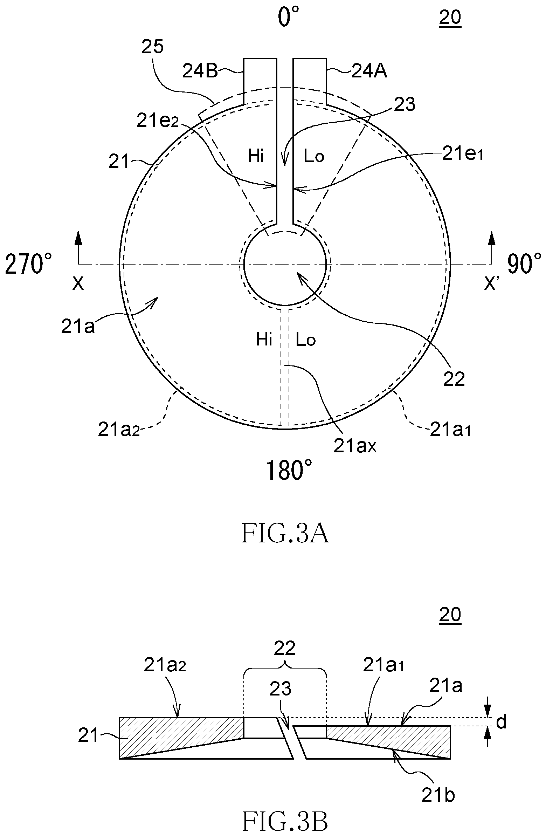

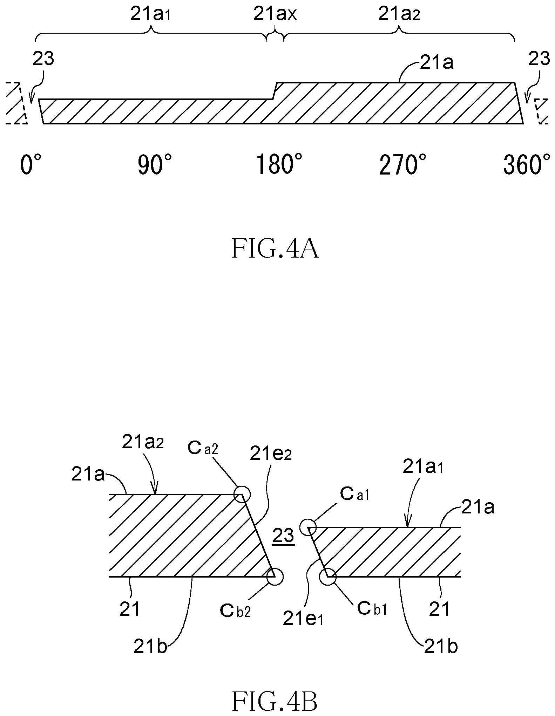

FIG. 2 is a schematic perspective view illustrating the configuration of the induction heating coil 20 according to a first embodiment of the present invention. FIGS. 3A and 3B are configuration views of the induction heating coil 20 illustrated in FIG. 2, in which FIG. 3A is a plan view, and FIG. 3B is a cross-sectional view taken along the line X-X' in FIG. 3A. FIG. 4A is a view illustrating the height profile of the upper surface of a coil body, and FIG. 4B is a cross-sectional view of a slit.

As illustrated in FIG. 2, FIG. 3A, FIG. 3B, FIG. 4A and FIG. 4B, the induction heating coil 20 has a coil body 21 formed of a coil conductor with a flat ring shape, an opening 22 formed at the center of the coil body 21 in plan view, a slit 23 substantially radially extending from the opening 22 to the outer peripheral end to separate one end (first end) 21e₁ of the coil body 21 in the circumferential direction and the other end (second end) 21e₂ thereof from each other, and a pair of terminal electrodes 24A and 24B connected respectively to the first and second ends 21e₁ and 21e₂ of the coil body 21. The coil body 21 is connected to the high-frequency oscillator through the terminal electrodes 24A and 24B.

Typically, the outer diameter of the coil body 21 is larger than the diameter of the raw material rod 2, and the inner diameter (diameter of the opening 22) of the coil body 21 is smaller than the diameter of the raw material rod 2. An upper surface 21a of the coil body 21 may be a slope inclined upward from the inner circumferential side toward the outer peripheral side or may be a horizontal surface. A lower surface 21b of the coil body 21 may be a slope inclined downward from the inner circumferential side toward the outer peripheral side or may be a horizontal surface.

As illustrated in FIG. 2 and FIG. 3A, the slit 23 penetrates the coil body 21 from the upper surface 21a to the lower surface 21b to cut one point of the coil body 21 in the circumferential direction. The slit 23 is formed not vertically but obliquely in cross section and, in particular, formed so as to approach the first end 21e₁ from the upper surface 21a toward the lower surface 21b. Thus, as illustrated in FIG. 4B, a corner Cₐ₁ on the upper surface 21a side of the first end 21e₁ of the coil body 21, which is positioned to the right of the slit 23, has an acute angle, and a corner Cₐ₂ on the upper surface 21a side of the second end 21e₂ of the coil body 21, which is positioned to the left of the slit 23, has an obtuse angle. Conversely, a corner C_{b1} on the lower surface 21b side of the first end 21e₁ has an obtuse angle, and a corner C_{b2} on the lower surface 21b side of the second end 21e₂ has an acute angle.

When the slit 23 is formed vertically in cross section, a current flowing at the first end 21e₁ of the coil body 21 along the slit 23 and a current flowing at the second end 21e₂ of the coil body 21 along the slit 23 generate a magnetic field having the same direction, so that the magnetic field is emphasized at the position around the slit 23, with the result that the magnetic field distribution of the induction heating coil 20 has a very large deviation in the circumferential direction. On the other hand, when the slit 23 is formed obliquely in cross section, the magnetic field concentration around the slit 23 can be relaxed.

The height of the upper surface 21a of the coil body 21 differs between the left and right of the slit 23. That is, the upper surface 21a of the coil body 21 is constituted by two surfaces facing each other across the slit 23 and having different heights : the right-side area of the slit 23 as viewed from the opening 22 is a lower stage surface 21a₁, and the left-side area of the slit 23 is an upper stage surface 21a₂.

While a height difference d (see FIG. 3B) between the lower stage surface 21a₁ and the upper stage surface 21a₂ differs depending on the diameter of the raw material rod 2, it is preferably 2 mm or more and 10 mm or less. When the height difference d is less than 2 mm, an effect of reducing a variation in the height of the melt surface of the raw material becomes insufficient, and when the height difference d exceeds 10 mm, the height variation of the melt surface may actually become large.

When the direction of a center line of the slit 23 substantially radially extending from the center of the opening 22 is assumed to be 0° (reference position), the lower stage surface 21a₁ circumferentially extends in an angular range of 0° to 180° in the clockwise direction from the reference position. On the other hand, the upper stage surface 21a₂ circumferentially extends in an angular range of 180° to 360° in the clockwise direction from the reference position. The formation area of the lower stage surface 21a₁ is adjacent to the first end 21e₁ positioned to the right of the slit 23 and circumferentially extends from the first end 21e₁ in the clockwise direction. The formation area of the upper stage surface 21a₂ is adjacent to the second end 21e₂ positioned to the left of the slit 23 and circumferentially extends from the second end 21e₂ in the counterclockwise direction.

A boundary part 21aₓ between the lower stage surface 21a₂ and the upper stage surface 21a₂ is located at 180° position in the clockwise (or counterclockwise) direction from the reference position. Thus, about a half of the area of the upper surface 21a of the coil body 21 is the lower stage surface 21a₁, and the remaining half is the upper stage surface 21a₂.

As described above, the formation area of the lower stage surface 21a₁ includes a slit neighborhood area 25 on the first end 21e₁ side, and the formation area of the upper stage surface 21a₂ includes a slit neighborhood area 25 on the second end 21e₂ side. The "slit neighborhood area" refers to a circumferential area around the slit 23 that extends to both sides of the slit 23 and can be defined as a fan-like area with an angular range of ±30° around the slit 23. The slit neighborhood area 25 on the first end 21e₁ side is defined as an area with an angular range of 0° to 30° circumferentially extending in the clockwise direction from the center line of the slit 23, and the slit neighborhood area 25 on the second end 21e₂ side is defined as an area with an angular range of 0° to 30° circumferentially extending in the counterclockwise direction from the center line of the slit 23 (area with an angular range of 330° to 360° circumferentially extending in the clockwise direction from the center line of the slit 23) .

The step surface of the boundary part 21aₓ between the lower stage surface 21a₁ and upper stage surface 21a₂ is preferably gently inclined, and the inclination angle thereof is preferably 60° or less, particularly 45° or less. When the inclination angle of the boundary part 21aₓ is 60° or less, the upper surface 21a of the coil body 21 can be easily subjected to step processing and mirror finishing.

To make the height of the lower stage surface 21a₁ lower than the height of the upper stage surface 21a₂ as described above, the thickness of the coil body 21 in the formation area of the upper stage surface 21a₂ is preferably smaller than the thickness of the coil body 21 in the formation area of the lower stage surface 21a₁.

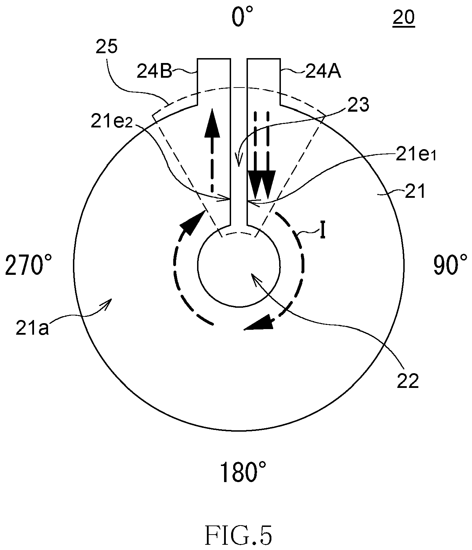

FIG. 5 is a schematic view illustrating a current flow inside the coil body 21.

As denoted by the arrow in FIG. 5, the current in the induction heating coil 20 flows in a path where the distance between the pair of terminal electrodes 24A and 24B is the shortest and is concentrated around the edge of the coil body 21. Accordingly, the current flowing in the coil body 21 is concentrated in the slit neighborhood area 25, resulting in an increase in the heat generation from the slit neighborhood area 25. On the other hand, an area (slit remote area) separated remotely from the slit 23 does not undergo current concentration and is small in heat generation. Thus, heating in the circumferential direction becomes non-uniform at the outer peripheral portion of the raw material rod 2, making it difficult to melt the raw material rod 2 uniformly in the circumferential direction. Further, when the slit 23 is formed obliquely in cross section, current is concentrated on the acute-angled corner Cₐ₁ of the two corners (Cₐ₁ and Cₐ₂) on both sides of the slit 23, so that the heat generation from the first end 21e₁ having the acute-angled corner Cₐ₁ becomes larger.

When the raw material rod 2 disposed above the induction heating coil 20 is being rotated in, for example, the clockwise direction, any circumferential point on the raw material rod 2 is significantly heated around the slit, and thus a large amount of molten silicon is produced there. Thereafter, the point is gradually separated from the slit 23, and the heat generation from the raw material rod 2 also gradually decreases. The position and inclination of the center axis of the raw material rod 2 typically include a slight error, so the height variation of the raw material melt surface in the circumferential direction is considered to be influenced by a slight eccentric rotation or the like of the raw material rod 2.

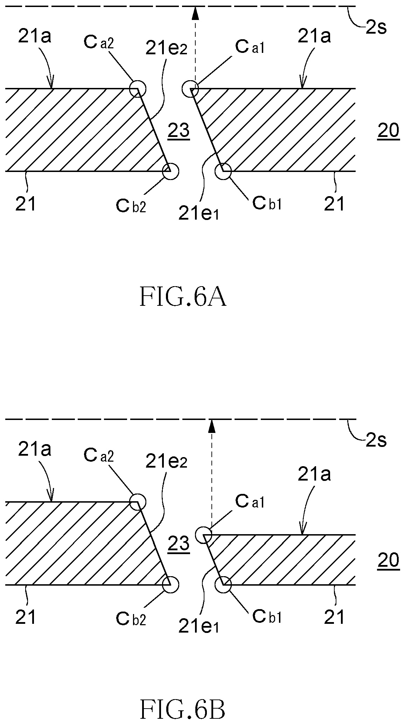

FIGS. 6A and 6B are schematic views for explaining the coil shape according to the present invention, in which FIG. 6A is a conventional coil shape, and FIG. 6B is a coil shape of the present invention.

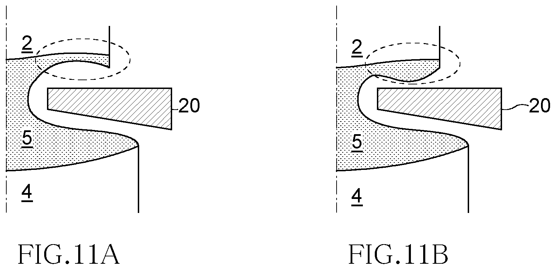

As illustrated in FIG. 6A, in the conventional induction heating coil 20, the upper surface 21a of the coil body 21 has the same height on both sides of the slit 23. Thus, when the raw material rod 2 is heated using the conventional induction heating coil 20, the melted amount of the raw material increases in the slit neighborhood area on the first end 21e₁ side within a certain circumferential range from the position (reference position) of the slit 23, with the result that melt-up of the melt surface of the raw material rod 2 becomes large as illustrated in FIG. 11A. On the other hand, the melted amount of the raw material is small in the area excluding the slit neighborhood area on the first end 21e₁ side, with the result that the height position of the melt surface of the raw material rod 2 is lowered as illustrated in FIG. 11B. As a result, the melt surface of the raw material rod 2 that is opposite to the upper surface 21a of the induction heating coil 20 becomes non-uniform in height in the circumferential direction. In particular, when the upper surface around the slit 23 having the acute-angled corner on the upper surface 21a side is the same in height as its surrounding portion, a circumferential variation in the heating distribution of the raw material further increases due to a very large amount of heat generation from the acute-angled corner.

The height variation of the melt surface of the raw material rod 2 gradually increases as the crystal growth process advances, and when the melt surface is brought into contact with the coil surface, the crystal growth process cannot be continued. Such a phenomenon becomes conspicuous as the diameter of the raw material rod 2 increases. This is considered to be because it becomes harder for heat to be radiated from the lower end portion of the raw material rod 2 as the raw material diameter increases to make the interface shape likely to be deformed due to high temperature of the melt surface.

On the other hand, as illustrated in FIG. 6B, in the induction heating coil 20 according to the present embodiment, the upper surface 21a of the slit neighborhood area 25 on the right side of the slit 23 and the upper surface 21a of the slit neighborhood area 25 on the left side of the slit 23 differ in height from each other. In particular, the upper surface 21a on the first end 21e₁ side having the acute-angled corner is lower in height than other areas, particularly, the upper surface 21a on the second end 21e₂ side.

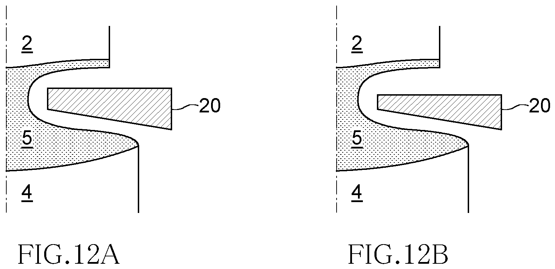

This can keep the upper surface 21a on the first end 21e₁ side of the slit 23 remote from a melt surface 2s of the raw material rod 2, thereby reducing heat generation of the raw material on the right side of the slit 23 irrespective of the rotation direction of the raw material rod 2, which can reduce the raw material melted amount. That is, as illustrated in FIG. 12A, excessive melt-up of the melt surface of the raw material rod 2 can be prevented in the slit neighborhood area on the right side of the slit 23. Further, as illustrated in FIG. 12B, in the slit neighborhood area on the left side of the slit 23, it is possible to prevent the raw material melt surface from being excessively reduced in height. Therefore, it is possible to make the heat generation from the raw material as uniform as possible and thus to reduce the height variation of the melt surface in the circumferential direction, which in turn can prevent contact between the melt surface and the coil surface.

As described above, in the induction heating coil 20 according to the present embodiment, the slit 23 extending substantially radially from the opening 22 of the coil body 21 is formed not vertically but obliquely, and the upper surface of the slit neighborhood area 25 on the first end 21e₁ side of the slit 23 at which the corner has an acute angle is lower in height than the upper surface of the slit remote area that is remoter from the slit 23 than the slit neighborhood area 25 is. This makes a portion around the slit having a large heat generation slightly remote from the raw material to reduce the influence thereof, thus making it possible to reduce a circumferential variation in the heating distribution of the raw material.

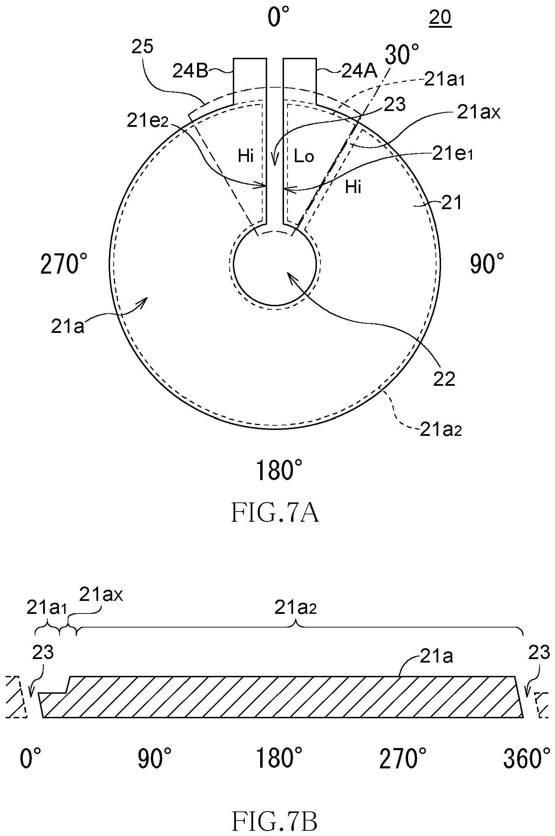

FIGS. 7A and 7B are views illustrating the configuration of the induction heating coil 20 according to a second embodiment of the present invention, in which FIG. 7A is a plan view, and FIG. 7B is a view illustrating the height profile of the upper surface of the coil body.

As illustrated in FIGS. 7A and 7B, the induction heating coil 20 according to the present embodiment is featured in that the lower stage surface 21a₁ circumferentially extends in an angular range of 0° to 30° in the clockwise direction from the position of the slit 23 and that the upper stage surface 21a₂ circumferentially extends in an angular range of 30° to 360°. That is, the lower stage surface is provided only in the slit neighborhood area 25 on the first end 21e₁ side. The boundary part 21aₓ between the lower stage surface 21a₁ and the upper stage surface 21a₂ is located at 30° position in the clockwise direction from the position of the slit 23. Other configurations are the same as those of the first embodiment.

When the end position in the circumferential direction of the formation area of the lower stage surface 21a₁ is less than 30° in an angular position as described above, an effect of uniformizing the melt surface obtained by reducing the height of the upper surface 21a on the first end 21e₁ side of the slit 23 becomes insufficient, thus increasing the probability of contact between the raw material melt surface and the coil surface. However, in the present embodiment, the lower stage surface 21a₁ circumferentially extends in an angular range of 0° to 30° in the clockwise direction from the position of the slit 23, making it possible to uniformize the melt surface.

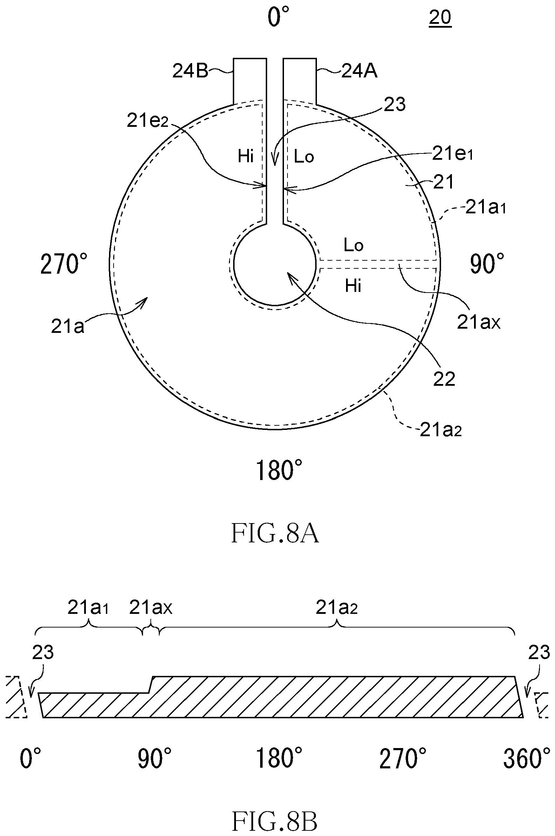

FIGS. 8A and 8B are views illustrating the configuration of the induction heating coil 20 according to a third embodiment of the present invention, in which FIG. 8A is a plan view, and FIG. 8B is a view illustrating the height profile of the upper surface of the coil body.

As illustrated in FIGS. 8A and 8B, the induction heating coil 20 according to the present embodiment is featured in that the lower stage surface 21a₁ circumferentially extends in an angular range of 0° to 90° in the clockwise direction from the position of the slit 23 and that the upper stage surface 21a₂ circumferentially extends in an angular range of 90° to 360°. The boundary part 21aₓ between the lower stage surface 21a₁ and the upper stage surface 21a₂ is located at 90° position in the clockwise direction from the position of the slit 23. Other configurations are the same as those of the first embodiment.

According to the present embodiment, it is possible to make the circumferential heating distribution of the raw material rod as uniform as possible as in the first embodiment. This can reduce the circumferential height variation of the melt surface of the raw material rod, which in turn can prevent contact between the melt surface and the coil surface.

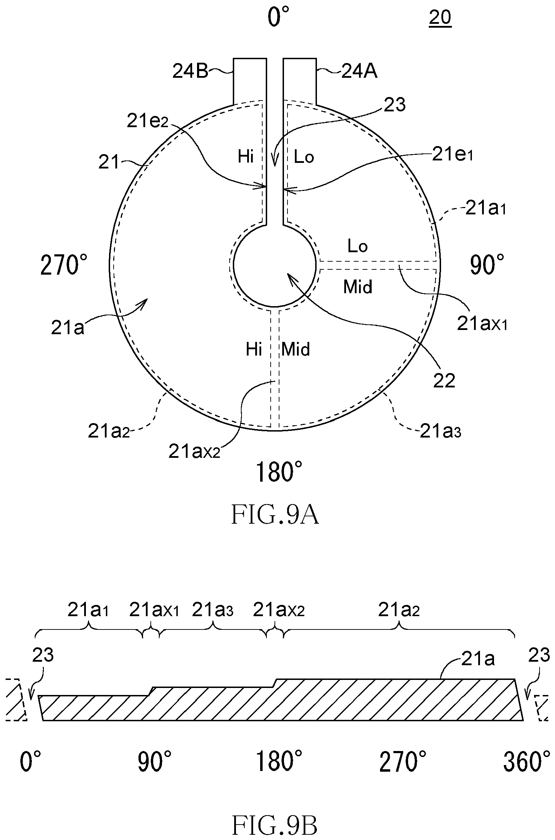

FIGS. 9A and 9B are views illustrating the configuration of the induction heating coil 20 according to a fourth embodiment of the present invention, in which FIG. 9A is a plan view, and FIG. 9B is a view illustrating the height profile of the upper surface of the coil body.

As illustrated in FIGS. 9A and 9B, the induction heating coil 20 according to the present embodiment is featured in that the upper surface 21a of the coil body 21 is constituted by three surfaces having mutually different heights. In more detail, the lower stage surface 21a₁ circumferentially extends in an angular range of 0° to 90° in the clockwise direction from the position of the slit 23, a middle stage surface 21ₐ₃ circumferentially extends in an angular range of 90° to 180°, and the upper stage surface 21a₂ circumferentially extends in an angular range of 180° to 360°. A boundary part 21aₓ₁ between the upper stage surface 21a₂ and the middle stage surface 21ₐ₃ is located at 180° position in the clockwise direction from the position of the slit 23, and a boundary part 21aₓ₂ between the middle stage surface 21ₐ₃ and the lower stage surface 21a₂ is located at 90° position in the clockwise direction from the position of the slit 23.

The height difference d between the lower stage surface 21a₂ and the upper stage surface 21a₂ is 2 mm, for example. The lower stage surface 21a₁ is higher in height than the middle stage surface 21ₐ₃ by 1 mm, and the middle stage surface 21ₐ₃ is higher in height than the upper stage surface 21a₂ by 1 mm. By thus providing the middle stage surface 21ₐ₃ between the lower stage surface 21a₂ and the upper stage surface 21a₂ and setting more finely a height change of the upper surface 21a of the coil body 21 in the circumferential direction, it is possible to smooth a circumferential change in the heating temperature of the raw material rod 2.

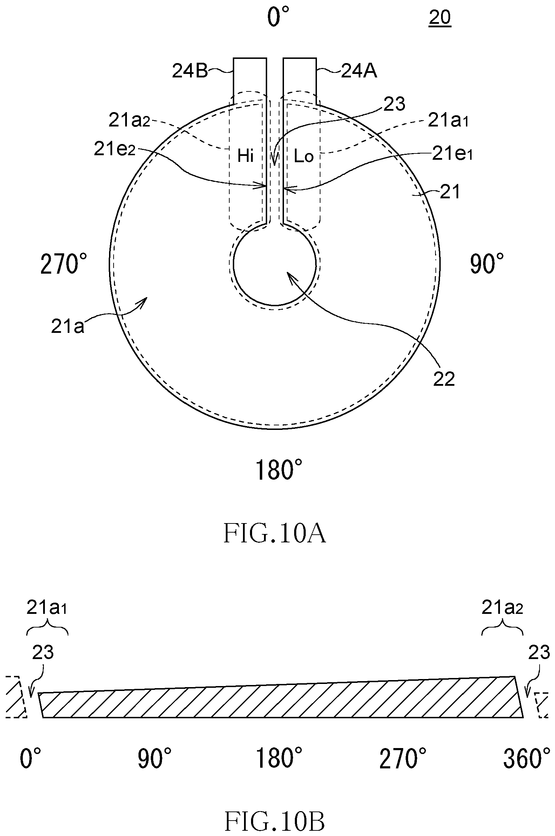

FIGS. 10A and 10B are views illustrating the configuration of the induction heating coil 20 according to a fifth embodiment of the present invention, in which FIG. 10A is a plan view, and FIG. 10B is a view illustrating the height profile of the upper surface of the coil body.

As illustrated in FIGS. 10A and 10B, the induction heating coil 20 according to the present embodiment is featured in that the height of the upper surface 21a of the coil body 21 linearly changes from the first end 21e₁ on the right side of the slit 23 to the second end 21e₂ on the left side of the slit 23. This is obtained by arranging an infinite number of steps for changing the height of the upper surface 21a illustrated in FIG. 9B. Thus, the area on the right side of the slit 23 as viewed from the opening 22 is the lower stage surface 21a₁, and the area on the left side of the slit 23 as viewed from the opening 22 is the upper stage surface 21a₂. According to the present embodiment, it is possible to smooth a circumferential change in the heating temperature of the raw material rod 2.

While the preferred embodiments of the present invention have been described, the present invention is not limited to the above embodiments, and various modifications may be made within the scope of the present invention, and all such modifications are included in the present invention.

For example, in the above embodiments, the upper surface 21a in the vicinity of the acute-angled corner Cₐ₁ is formed as the lower stage surface, and the upper surface 21a in the vicinity of the obtuse-angled corner Cₐ₂ is formed as the upper stage surface; however, since the temperature of the upper surface 21a of the slit neighborhood area 25 becomes high not only in the vicinity of the acute-angled corner Cₐ₁ but also in the vicinity of the obtuse-angled corner Cₐ₂, the height of the upper surface 21a on both sides of the slit 23 may be reduced. That is, the lower stage surface 21a₁ may be provided both in the vicinity of the acute-angled corner Cₐ₂ and in the vicinity of the obtuse-angled corner Cₐ₂. In this case, the thickness of the coil body 21 in the vicinity of the acute-angled corner Cₐ₁ is preferably made smaller.

### [Example]

### (Comparative Example)

There was prepared an induction heating coil (see FIG. 6A) having a conventional structure in which the upper surface thereof on the left and right sides of the slit had no height difference and was entirely flat, and this induction heating coil was used to produce a silicon single crystal having a diameter of about 200 mm by the FZ method. A polycrystalline silicon rod with a diameter of 160 mm produced according to a monosilane method was adopted for the raw material rod. The slit 23 of the induction heating coil was an oblique slit and was formed so as to approach the right side one end of the coil from the upper surface toward the lower surface. Accordingly, the upper surface side corner at the first end had an acute angle, and the upper surface side corner at the second end positioned opposite to the acute-angled corner on the first end side across the slit had an obtuse angle.

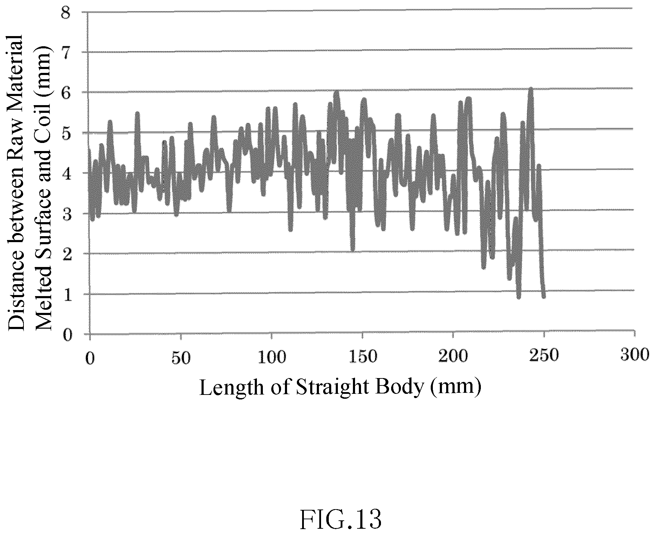

FIG. 13 is a graph illustrating a result of measuring the distance (interval) between the raw material melt surface and the coil upper surface. As revealed by the graph of FIG. 13, a variation in the height of the melting zone on the raw material side was large, and the height variation of the melting zone lower surface on the raw material side became large during the crystal growth process, with the result that the distance fell below 1 mm when the length of the straight body was equal to or more than 200 mm. Although the silicon single crystal was able to be grown without problem, the melt surface was likely to contact the coil surface at any moment.

### (Example)

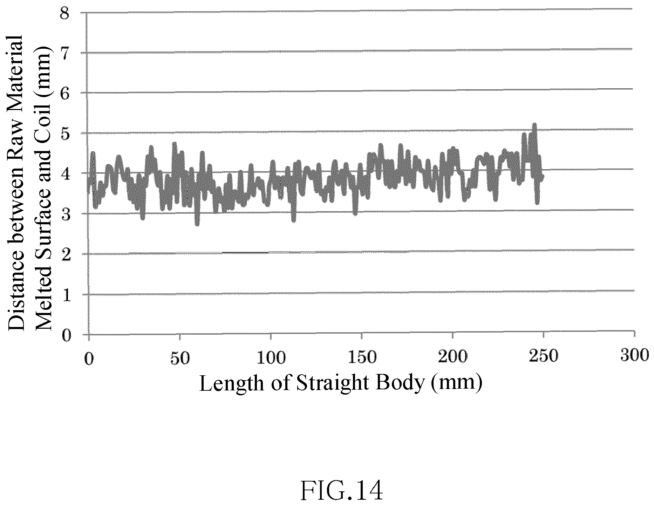

There was prepared an induction heating coil (see FIGS. 3A, 3B, 4A, and 4B) according to Example 1 in which a circumferential area with an angular range of 0° to 180° in the clockwise direction from the position of the slit was defined as the lower stage surface, a circumferential area with an angular range of 180° to 360° was defined as the upper stage surface, and the height difference between the lower and upper stage surfaces was set to 2 mm. This induction heating coil was used to produce a silicon single crystal having a diameter of about 200 mm under the same conditions as in the Comparative Example. As a result, as revealed by the graph of FIG. 14, the height variation of the melting zone on the raw material side was reduced. In this Example, a clearance of 3 mm or more was obtained left between the melt surface and the coil surface even in the latter part of the crystal growth process, so the single crystal was grown safely.

### [Reference Signs List]

1: Single crystal manufacturing apparatus
2: Raw material rod
2s: Melt surface of raw material rod
3: Seed crystal
4: Silicon single crystal
5: Melting zone
10: Reaction furnace
11: Upper shaft
12: Lower shaft
14: Single crystal weight holder
15: Gas doping apparatus
16: Raw material holder
17: Seed crystal holder
20: Induction heating coil
21: Coil body
21a: Upper surface of coil body
21a₁ Lower stage surface
21a₂: Upper stage surface
21a₃: Middle stage surface
21aₓ, 21aₓ₁, 21aₓ₂: Boundary part (step)
21b: Lower surface of coil body
21e₁: First end of coil body
21e₂: Second end of coil body
22: Opening
23: Slit
24A, 24B: Terminal electrode
25: Slit neighborhood area
Cₐ₁, Cₐ₂: Corner
C_{b1}, C_{b2}: Corner

## Claims

1. An induction heating coil used to manufacture a single crystal by an FZ method, comprising:
an annular coil body that has an opening in the center thereof and that has first and second ends separated from each other by a slit extending in a substantially radial direction from the opening, wherein
the slit is an oblique slit that obliquely cuts the coil body from an upper surface side thereof to a lower surface side such that a corner on the upper surface side of the first end has an acute angle and that a corner on the upper surface side of the second end has an obtuse angle,
the upper surface of the coil body has an upper stage surface and a lower stage surface,
the lower stage surface is provided at a slit neighborhood area on the first end side, and
the upper stage surface is provided in an area excluding a formation area of the lower stage surface.

2. The induction heating coil according to Claim 1, wherein
a height difference between the upper and lower stage surfaces is 2 mm or more.

3. The induction heating coil according to Claim 1, wherein
a thickness of the coil body in the formation area of the lower stage surface is smaller than a thickness of the coil body in a formation area of the upper stage surface.

4. The induction heating coil according to Claim 1, wherein
the formation area of the upper stage surface includes the slit neighborhood area on the second end side.

5. The induction heating coil according to Claim 1, wherein
when a direction of a center line of the slit extending in a substantially radial direction from the center of the opening is assumed to be 0°, the lower stage surface circumferentially extends in an angular range of at least 0° to 30°.

6. The induction heating coil according to Claim 5, wherein
the lower stage surface circumferentially extends in an angular range of 0° to 90°, and the upper stage surface circumferentially extends in an angular range of at least 180° to 360°.

7. The induction heating coil according to Claim 5, wherein
the lower stage surface circumferentially extends in an angular range of 0° to 180°, and the upper stage surface circumferentially extends in an angular range of at least 180° to 360°.

8. A single crystal manufacturing apparatus used to manufacture a single crystal by an FZ method, comprising:
an upper shaft that rotatably and vertically movably supports a raw material rod;
a lower shaft that is disposed below the upper shaft and rotatably and vertically movably supports a seed crystal; and
the induction heating coil according to Claim 1 that heats the raw material rod.
